# EUROPÄISCHE PATENTSCHRIFT

(11) **EP 0 781 051 B1**
(45) Veröffentlichungstag und Bekanntmachung des Hinweises auf die Patenterteilung: **31.03.2004**
(21) Anmeldenummer: 96119841.3
(22) Anmeldetag: 11.12.1996
(51) Int. Cl.: H04N 7/26, H04N 7/58

(54) **Übertragung von hierarchischen digitalen Bildsignalen**
Hierarchical transmission of digital image signals
Transmission hiérarchique de signaux numériques d'images

(30) Priorität: 20.12.1995 DE 19547707
(43) Veröffentlichungstag der Anmeldung: 25.06.1997
(73) Patentinhaber: DEUTSCHE THOMSON-BRANDT GMBH, 78048 Villingen-Schwenningen (DE)
(72) Erfinder: Adolph, Dirk, 30952 Ronnenberg (DE); Herpel, Carsten, 30171 Hannover (DE)
(74) Vertreter: Hartnack, Wolfgang, Dipl.-Ing.

(56) Entgegenhaltungen:
- WO-A-95/26595
- CA-A- 2 108 338
- US-A- 5 122 875
- US-A- 5 140 417
- US-A- 5 231 486
- US-A- 5 289 276
- US-A- 5 461 619
- JOSEPH K ET AL: "MPEG++: A ROBUST COMPRESSION AND TRANSPORT SYSTEM FOR DIGITAL HDTV" SIGNAL PROCESSING. IMAGE COMMUNICATION, Bd. 4, Nr. 4 / 05, 1. August 1992, Seiten 307-323, XP000293751
- SIRACUSA R.J. ET AL: 'Flexible and Robust Packet Transport fpr Digital HDTV' IEEE JOURNAL ON SELECTED AREAS IN COMMUNICATIONS Bd. 11, Nr. 1, 1993, NEW YORK, Seiten 88 - 98

## Beschreibung

Die Erfindung betrifft ein Verfahren, einen Encoder und einen Decoder zur Übertragung von hierarchisch in mehrere Teile gegliederten digitalen Signalen, insbesondere zur hierarchischen terrestrischen Übertragung von digitalen Fernsehsignalen.

### Stand der Technik

Digitale Übertragungsverfahren weisen insbesondere in terrestrischen Kanälen ein abruptes Übergangsverhalten auf. Solange die Empfangsfeldstärke eine nahezu fehlerfreie Dekodierung des digitalen Datenstroms ermöglicht, liegt eine gleichbleibend gute Signalqualität vor. Wird jedoch ein Mindestmaß für die Feldstärke unterschritten, so kommt es zu einer abrupten Erhöhung der Bitfehler und im Extremfall zu einem völligen Ausfall des zu empfangenden Programms. Um dieses Verhalten zu verhindern, werden wichtige Signalanteile wie z.B. die groben Strukturen eines Bildes mit höherem Fehlerschutz versehen, d.h. es wird eine Datenhierarchie eingeführt. Damit werden Bildsignale erzeugt, die aus wichtigen und weniger wichtigen Bildanteilen bestehen, so daß bei einem Verlust der weniger wichtigen Anteile das Bild zumindest noch in geringerer Qualität dekodiert und dargestellt werden kann.

Eine solche hierarchische Quellenkodierung wird auch im Rahmen des deutschen Verbundprojektes Hierarchical Digital Television Transmission (HDTVT) für HDTV-Programme sowie die zugehörigen Tonsignale und Zusatzinformationen angewendet, wobei eine dreilagige Codierung des Videosignals erfolgt. Es wird im bestgeschützten Teilkanal 1 lediglich ein Videosignal mit TV-Auflösung übertragen, im Teilkanal 2 ein HDTV-Signal in verminderter Qualität (HD1) und in dem am schwächsten geschützten Teilkanal 3 schließlich die Restinformation, die bei Decodierung aller drei Signale dann das HDTV-Signal in voller Qualität ergibt (HD2). Hiermit wird gewährleistet, daß der Empfang des HDTV-Signals bei schwächer werdendem Sendesignal nicht abrupt abreißt, sondern zunächst in zwei Stufen schlechter wird. Der Verlust von besonders wichtigen Informationen des Videosignals kann dennoch selbst bei geringer Fehlerrate des jeweiligen Teilkanals zu einem Bildausfall und durch die üblicherweise angewendete Prädiktion bei der Videocodierung zu länger sichtbaren Fehlern führen.

Ein Ansatz zur Lösung dieses Problems für MPEG-kodierte Bildsignale wird in "Flexible and Robust Packet Transport for Digital HDTV" (Robert J.Siracusa et al., IEEE Journal on Selected Areas in Communications, 11(1993) January, No.1) sowie in "MPEG++: A robust compression and transport system for digital HDTV" (K.Joseph et al., Signal Processing: Image Communication 4(1992), p.307 ff) beschrieben. Er beinhaltet eine Aufteilung der Transportpakete mit Bildinformationen in einen wichtigeren und einen weniger wichtigen Teil, mit anschließender Übertragung auf zwei Trägerfrequenzen unterschiedlicher Sendeleistung und damit unterschiedlicher Fehleranfälligkeit. Mit diesem verfahren kann jedoch bei Störung des weniger geschützten Kanals keine kontinuierliche Wiedergabe mit TV-Auflösung erfolgen.

### Erfindung

Der Erfindung liegt die Aufgabe zugrunde, ein Verfahren zur hierarchischen Übertragung von digitalen Signalen anzugeben, bei der für die besonders wichtigen Informationen des Videosignals ein höherer Fehlerschutz vorgesehen wird, um insbesondere die Wahrnehmbarkeit von Fehlern und Bildausfällen beim terrestrischen Empfang dieser Signale zu reduzieren. Diese Aufgabe wird durch das in Anspruch 1 angegebene Verfahren gelöst.

Der Erfindung liegt die weitere Aufgabe zugrunde, einen Encoder und Decoder zur Anwendung des erfindungsgemäßen Verfahrens anzugeben. Diese Aufgabe wird durch den in Anspruch 6 angegebenen Encoder und den in Anspruch 8 angegebenen Decoder gelöst.

Der Verlust von Sequenz- bzw. Bildheaderinformationen in einem Videosignal kann dazu führen, daß das darauffolgende Bild nicht decodiert werden kann. Dieses kann selbst bei geringer Fehlerrate sehr störend sein, da durch die zeitliche Prädiktion bei einer Videocodierung, wie sie zum Beispiel entsprechend dem MPEG2-Standard erfolgt, ein solcher Fehler bis zum nächsten intraframe-codierten Bild, d.h. maximal ca. 1/2 Sekunde sichtbar bleiben kann. Ein besonderer Schutz der besagten Headerinformationen kann diese länger sichtbaren Fehler eliminieren.

Erfindungsgemäß werden daher bei einer hierarchischen Übertragung in mehreren Teilkanälen die wichtigsten Informationen eines Videoteilkanals, insbesondere die jeweiligen Headerinformationen, in einem Teilkanal mit höherem Fehlerschutz übertragen.

Im Prinzip besteht das erfindungsgemäße Verfahren zur Übertragung von hierarchisch in mehrere Teile gegliederten digitalen Signalen in zugehörigen Teilkanälen, wobei die übergeordneten Kanäle einen höheren Fehlerschutz als die ihnen untergeordneten Teilkanäle aufweisen, darin, daß in mindestens einem übergeordneten Teilkanal ein Teil der digitalen Signale, die logisch zu einem der untergeordneten Teilkanäle gehören, übertragen werden.

Hierbei können in dem Teilkanal, der den höchsten Fehlerschutz aufweist, digitale Videosignale übertragen werden, die eine bestimmte Bildqualität gewährleisten und in den untergeordneten Teilkanälen zusätzliche Daten übertragen werden, die jeweils eine Verbesserung der Bildqualität ermöglichen, wobei vorteilhaft die Header für die Videodaten, die in dem hierarchisch am höchsten angeordneten Teilkanal übertragen werden, einen besseren Fehlerschutz erfahren, indem diese in dem selben Teilkanal mehrfach übertragen werden.

Vorzugsweise enthalten die jeweiligen Teile der digitalen Signale, die nicht im zugehörigen Teilkanal sondern in einem übergeordneten Kanal übertragen werden, die Header der Videodaten für diesen Signalteil.

Besonders vorteilhaft ist hierbei, die jeweiligen Teile der digitalen Signale, die nicht im zugehörigen Teilkanal sondern in einem übergeordneten Kanal übertragen werden, jeweils in dem direkt übergeordneten Teilkanal zu übertragen.

Erfolgt die Übertragung nach dem MPEG2-Systemmultiplex, so ist es weiterhin vorteilhaft, die Transportpakete, die Headerinformationen enthalten, durch Setzen eines Prioritätsbits zu markieren.

Im Prinzip besteht der erfindungsgemäße Encoder darin, daß in Quellencodern eine hierarchische Kodierung in mehrere Teilsignale erfolgt, die Daten der Teilsignale in einem Multiplexer zu einem Datenstrom zusammengefaßt werden und in einer Kanalschnittstelle eine Aufteilung des Datenstroms auf mehrere Teilkanäle mit unterschiedlichen Fehlerschutz derart erfolgt, daß in mindestens einem übergeordneten Teilkanal ein Teil der digitalen Signale, die logisch zu einem der untergeordneten Teilkanäle gehören, übertragen werden.

Vorteilhaft erfolgt hierbei in dem Multiplexer eine Kennzeichnung der Transportpakete, in denen Headerinformationen übertragen werden.

Im Prinzip besteht der erfindungsgemäße Decoder darin, daß in einer Kanalschnittstelle die Signale mehrerer Teilkanäle mit unterschiedlichem Fehlerschutz zu einem Datenstrom zusammengefaßt werden, die Daten anschließend in einem Demultiplexer wieder in mehrere Teilsignale aufgespalten werden, wobei aus mindestens einem übergeordneten Teilkanal ein Teil der digitalen Signale, die logisch zu einem der untergeordneten Teilkanäle gehören, wieder in diesen untergeordneten Teilkanal transferiert werden und in Quellendecodern zu Videosignalen dekodiert werden.

Vorteilhaft wird hierbei in dem Demultiplexer eine encoderseitige Kennzeichnung der Transportpakete, in denen Headerinformationen übertragen werden, ausgewertet.

### Zeichnungen

Anhand der Zeichnungen werden Ausführungsbeispiele der Erfindung beschrieben. Diese zeigen in:
- Fig. 1: eine erfindungsgemäße hierarchische Übertragung bei drei Videoteilkanälen,
- Fig. 2: den Aufbau einer Transportpaketstruktur,
- Fig. 3: das Blockschaltbild eines Senders für die erfindungsgemäße Übertragung,
- Fig. 4: das Blockschaltbild eines Empfängers für den Empfang von erfindungsgemäß übertragenen Signalen.

### Ausführungs-Beispiele

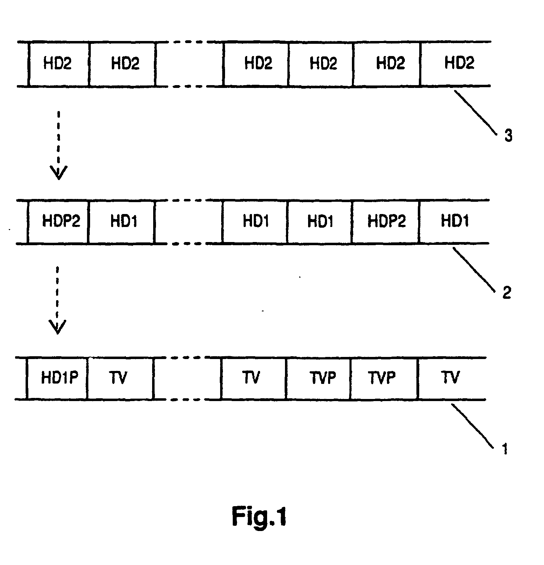

In Fig. 1 ist schematisch die erfindungsgemäße Aufteilung der Videodaten auf drei (virtuelle) Teilkanäle mit unterschiedlichem Fehlerschutz dargestellt
(Kanal 1: höchster Fehlerschutz,
Kanal 2: mittlerer Fehlerschutz,
Kanal 3: niedrigster Fehlerschutz).
Übertragungskanal 3 wird lediglich für die Videosignale HD2 des HD2-Datenstroms genutzt. Die Headerinformationen des HD2-Datenstroms HD2P werden zusammen mit den Videosignalen des HD1-Datenstroms HD1 in dem besser geschützten Übertragungskanal 2 übertragen. Die Headerinformationen des HD1-Datenstroms HD1P wiederum werden in dem am besten geschützten Übertragungskanal 1 übertragen. In diesem Teilkanal erfolgt auch die Übertragung der Videosignale mit lediglich normaler TV-Auflösung TV und zwar beim HDTVT-System einschließlich der zugehörigen Headerinformationen TVP. Ein zusätzlicher Schutz dieser Header kann zum einen erreicht werden, indem ein weiterer Teilkanal mit besserem Fehlerschutz geschaffen wird, und zum anderen ist es z. B. im Rahmen der MPEG2-Systems Spezifikation möglich, Pakete mehrfach hintereinander zu übertragen, wie dieses in Fig. 1 ebenfalls angedeutet ist.

Durch die beschriebene hierarchische Übertragung ist gewährleistet, daß die Header des HD2-Datenstromes erst dann fehlerhaft werden, wenn der Rest des HD2-Datenstromes nahezu völlig ausgefallen ist. Analog gilt dies für den HD1-Datenstrom und gegebenenfalls auch für den TV-Datenstrom.

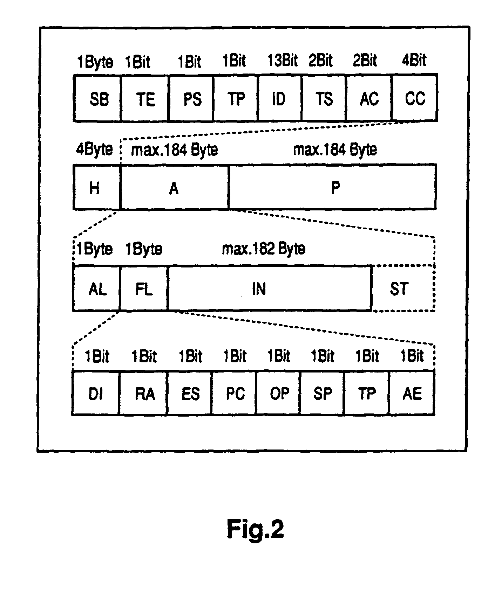

Die eigentliche Übertragung digitaler Videodaten erfolgt bevorzugt in sogenannten Transportpaketen. Fig. 2 zeigt den Aufbau eines Transportpaketes, wie es in der MPEG2-Systems Spezifikation spezifiziert ist und für HDTVT angewendet werden soll. Das Transportpaket hat eine feste Länge von 188 Byte, wobei 4 Byte auf den Header H des Transportpakets entfallen. Die verbleibenden 184 Byte können beliebig in einen Bereich zur Übertragung der Nutzinformation P (Payload) und einen Bereich zur Übertragung von zusätzlichen Kontroll- und Steuerinformationen A (Adaptation Field) aufgeteilt werden.

Der Header enthält hierbei die folgenden Bits, deren jeweilige Funktionen sich aus der MPEG-Spezifikation ergeben: Ein Sync_Byte SB, ein Transport_Error_Indikator-Bit TE, ein Payload_Unit_Start_Indicator-Bit PS, ein Transport_Priority-Bit TP, Packet_Identification-Bits ID, Transport_Scrambling_Control-Bits TS, Adaption_Field_Control-Bits AC, sowie Continuity_Counter-Bits CC.

Für weitere Steuerinformationen kann das bereits erwähnte Adaptation Field verwendet werden, das jedoch nicht verwendet werden muß. Die Länge des Adaptation Fields wird in einem Byte Adaptation_Field_Length AL übertragen, darauf folgt ein weiteres Byte FL bestehend aus acht einzelnen Kontrollbits DI, RA, ES, PC, OP, SP, TP, AE. Im Anschluß daran werden die eigentlichen Informationsdaten IN übertragen, sowie falls nötig Stopf-Bytes ST.

Die wichtigen Headerinformationen des Videodatenstroms (Sequenz- bzw. Bildheader) bestehen, wie nach der MPEG2-Videospezifikation abgeschätzt werden kann, aus maximal ca. 180 Byte. Dieses entspricht damit etwa der Payload eines Transportpaketes, so daß diese zur Übertragung der Headerinformationen verwendet werden kann.

Diejenigen Transportpakete, die als Nutzinformation die Headerinformationen aus einem oder mehreren der Teilkanäle enthalten, können durch Setzen des in dem Header des Transportpakets übertragenen Transport-Priority-Bits TP gekennzeichnet werden. Mit diesem Bit kann Transportpaketen eine unterschiedliche Priorität bei der Übertragung zugeordnet werden, eine Auswertung ist jedoch in der MPEG2-und HDTVT-Spezifikation bisher nicht vorgesehen.

Im Mittel ergibt sich bei einer Bildfolgefrequenz von 25 Hz eine Anzahl von ca. (25 + 2) * 2 zu kennzeichnenden Transportpaketen pro Sekunde (ca 81000 bit/s), da zusätzlich zu den Bilddaten ca. 2 Sequenzheader pro Sekunde übertragen werden, die Informationen für den wahlfreien Zugriff auf den Datenstrom enthalten. Im Übertragungskanal 1 wird damit von der für den TV-Teildatenstrom zur Verfügung stehenden Datenrate etwa 1,3 % für die Prioritätspakete des HD1-Stromes belegt, was eine nicht wahrnehmbare Verschlechterung des TV-Signales mit sich bringt. Dieser scheinbare Nachteil wird dadurch aufgewogen, daß unter Empfangsbedingungen, wo bereits eine gewisse Fehlerrate (z. B. 10⁻³) im Kanal 2 vorliegt, keine länger andauernden großflächigen Bildstörungen des HD1-Signales durch Headerverluste mehr auftreten.

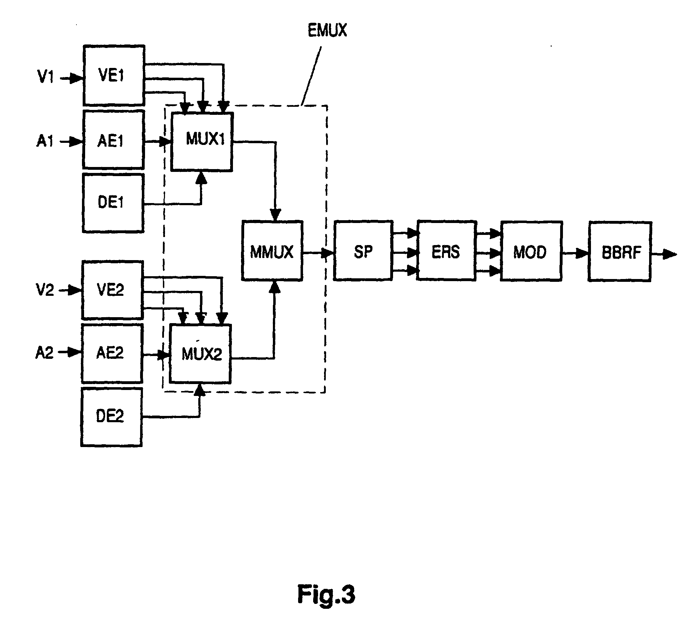

In Fig. 3 ist ein Blockdiagramm eines Senders für das erfindungsgemäße Übertragungsverfahren dargestellt, wobei exemplarisch eine Übertragung von zwei Programmen erfolgt.

Video- und Audiosignale V1, A1, V2, A2 werden jeweils einem Quellencoder VE1, AE1 bzw. VE2, AE2 zugeführt. Aus den quellencodierten Video- und Audiosignalen wird dann zusammen mit Zusatzdaten, die in einer Stufe DE1 bzw. DE2 generiert werden, in einem Programm-Multiplexer MUX1 bzw. MUX2 ein gemeinsamer Programmdatenstrom erzeugt. In einem Transport-Multiplexer MMUX werden dann die verschiedenen (im Beispiel von Fig.3: zwei) Programm-Datenströme zu einem Transportdatenstrom gemäß der MPEG2 Systems-Spezifikation zusammengefaßt, wobei eine Kennzeichnung der Transportpakete auf der Basis der Paketkennungen erfolgt. Während des Multiplexvorganges werden auch die Prioritätsbits gesetzt, da zu diesem Zeitpunkt bekannt ist, wie sich die Header gegebenenfalls auf mehrere Transportpakete verteilen. Gemäß den Kennzeichnungen durch die Paketkennungen und Prioritätsbits werden die einzelnen Teildatenströme dann von der Kanalschnittstelle SP (im Falle des HDTVT-Systems Splitter genannt) auf drei Teilkanäle verteilt, um die codierten Daten gemäß ihrer Wichtigkeit in Kanälen unterschiedlicher Fehlerhäufigkeit zu übertragen. Die Kanalschnittstelle SP ordnet hierbei die Pakete den drei Teilkanälen in der folgenden Weise zu:

| Paketkennung | Prioritätsbit | Übertragungskanal |
|---|---|---|
| TV | gesetzt | 1 |
| TV | - | 1 |
| HD1 | gesetzt | 1 |
| HD1 | - | 2 |
| HD2 | gesetzt | 2 |
| HD2 | - | 3 |

Die Signale werden dann in einem Coder ERS durch eine Reed-Solomon-Codierung mit einem äußeren Fehlerschutz versehen. In der darauffolgenden Encodereinheit MOD erfolgt eine Faltungscodierung zum inneren Fehlerschutz sowie eine digitale Modulation. Schließlich werden die Signale in einem darauffolgenden Modulator BBRF vom Basisband in eine für die Übertragung (per Satellit, per Kabel, terrestrisch) geeignete Form umgesetzt.

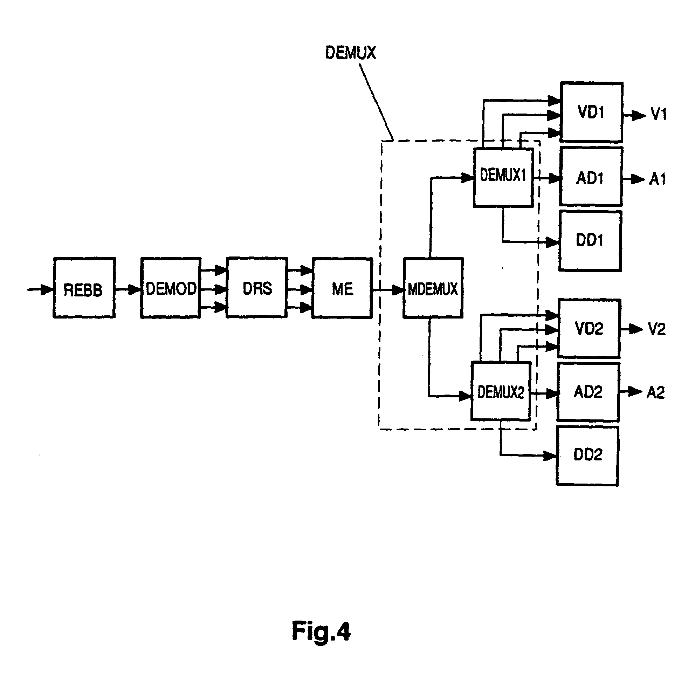

In Fig. 4 ist exemplarisch ein Blockdiagramm eines Empfängers für erfindungsgemäß übertragene Signale dargestellt, wiederum exemplarisch bei einer Übertragung von zwei Programmen. Es erfolgen die reziproken Verarbeitungsschritte des Encoders. Zunächst erfolgt in einem Demodulator RFBB eine Umsetzung der empfangenen Signale zurück in das Basisband. In der darauffolgenden Decodereinheit DEMOD erfolgt eine digitale Demodulation sowie eine Faltungsdecodierung, z. B. eine Viterbi-Decodierung, darauf folgt ein Reed-Solomon-Decoder DRS. In der Kanalschnittstelle ME (bei HDTVT Merger genannt) wird dann ein Transport-Datenstrom entsprechend MPEG2 erzeugt und durch den Demultiplexer MDEMUX in die verschiedenen Programmdatenströme aufgeteilt. Durch die Demultiplexer DEMUX1 und DEMUX2 werden die Programmdatenströme dann jeweils in Video-, Audio- und sonstige Daten aufgeteilt, die anschließend in den Decodereinheiten VD1, AD1; VD2, AD2 bzw. DD1, DD2 weiterverarbeitet werden und die Ausgangsvideodaten V1, V2 und die Ausgangsaudiodaten A1, A2 liefern.

Da die HDTVT-Decoderspezifikation nicht von einer festen Zuordnung der Videodatenströme zu den Teilkanälen ausgeht, kann ein erfindungsgemäß übertragener Datenstrom durch Auswerten des Prioritätsbits ohne weiteres decodiert werden.

Die Erfindung kann z.B. für digitale Fernsehsysteme wie DVB oder HDTV oder bei der magnetischen Aufzeichnung von digitalen Daten verwendet werden.

## Patentansprüche

1. Verfahren zur Übertragung oder Aufzeichnung von digitalen Datenpaketen, die Daten (TV,HD1,HD2) und Header-Informationen (TVP,HD1P,HD2P) enthalten, wobei ein erster Teil der Daten und die zugehörigen Header-Informationen (TV,TVP) zur Wiedergabe in normaler Qualität ausreicht, und weitere Teile der Daten (HD1,HD2) zusammen mit ihren jeweiligen Header-Informationen (HD1P, HDP2) die Wiedergabe in verbesserter Qualität ermöglichen, die folgenden Schritte enthaltend:
- Aufteilung der Daten (TV,HD1,HD2) und ihrer Header-Informationen (TVP,HD1P,HD2P) auf mehrere hierarchische Teilkanäle (1-3), wobei die Daten (TV,HD1) für normale Wiedergabequalität und die Header-Informationen für verbesserte Wiedergabequalität (HD1P,HD2P) dem gleichen Teilkanal (1,2) zugeordnet werden; und
- Übertragung oder Aufzeichnung der Teilkanäle (1-3) mit unterschiedlich gutem Fehlerschutz, wobei für die Daten innerhalb eines Teilkanals jeweils der gleiche Fehlerschutz gilt, und wobei übergeordnete Teilkanäle (1,2) höheren Fehlerschutz haben als untergeordnete Teilkanäle (2,3), und wobei die zur Wiedergabe in normaler Qualität ausreichenden Daten (TV,TVP) in dem Teilkanal (1) mit dem besten Fehlerschutz übertragen oder aufgezeichnet werden.

2. Verfahren nach Anspruch 1, wobei die Header-Informationen (HD1P,HDP2), die einem übergeordneten Teilkanal zugeordnet werden, dem jeweils direkt übergeordneten Teilkanal (1,2) zugeordnet werden.

3. Verfahren nach einem der Ansprüche 1 oder 2, wobei die Header-Informationen (TVP), die zu den Daten (TV) mit der geringsten Auflösung gehören und im am besten geschützten Teilkanal (1) übertragen werden, mehrfach übertragen werden.

4. Verfahren nach einem der Ansprüche 1 bis 3, wobei die Übertragung nach einem MPEG-Systemmultiplex erfolgt und diejenigen Transportpakete, die Header-Informationen enthalten (TVP,HD1P,HDP2), durch Setzen eines Prioritätsbits (TP) markiert werden.

5. Verfahren zum Dekodieren von hierarchisch in mehreren Teilkanälen (1-3) übertragenen oder aufgezeichneten digitalen Signalen, wobei die übergeordneten Teilkanäle (1,2) einen höheren Fehlerschutz aufweisen als die ihnen untergeordneten Teilkanäle (2,3), die folgenden Schritte enthaltend:
- Zusammenfassen der Signale der Teilkanäle (1-3) zu Teilsignalen, die Datenpakete (TV,HD1,HD2) und zugehörige Header-Informationen (TVP,HD1P,HDP2) enthalten, wobei das dem am besten geschützten Teilkanal (1) zugeordnete Teilsignal (TV,TVP) zur Wiedergabe mit normaler Qualität ausreichend ist, derart, dass die Header-Informationen (HD1P,HDP2) mindestens eines Teilsignals für erhöhte Qualität, dessen Datenpakete (HD1,HD2) einem untergeordneten Teilkanal (2,3) zugeordnet sind, aus einem anderen Teilkanal (1,2) transferiert werden, der diesem übergeordnet ist; und
- Dekodieren der Daten der Teilsignale zu Videosignalen.

6. Encoder für die hierarchische Übertragung oder Aufzeichnung von digitalen Signalen in mehreren Teilkanälen (1,2,3), wobei die übergeordneten Teilkanäle einen höheren Fehlerschutz aufweisen als die ihnen untergeordneten Teilkanäle, der die folgenden Bestandteile enthält:
- Quellencoder (VE1,VE2) für eine hierarchische Kodierung in mehrere Teilsignale, die Datenpakete (TV,HD1,HD2) und zugehörige Header-Informationen (TVP,HD1P,HDP2) enthalten, wobei eines dieser Teilsignale (TV,TVP) zur Wiedergabe in normaler Qualität ausreicht;
- Kanalschnittstelle (SP) zur Aufteilung der Teilsignale auf die Teilkanäle (1-3) mit unterschiedlichem Fehlerschutz, wobei das zur Wiedergabe in normaler Auflösung ausreichende Teilsignal (TV,TVP) dem am besten geschützten Teilkanal (1) zugeordnet wird, und wobei mindestens einem Teilkanal (1,2) die Header-Informationen (HD1P,HDP2) eines Teilsignals zugeordnet werden, dessen Datenpakete (HD1,HD2) einem anderen, diesem untergeordneten Teilkanal zugeordnet werden.

7. Encoder nach Anspruch 6, wobei eine Kennzeichnung der Transportpakete erfolgt, in denen Header-Informationen übertragen oder aufgezeichnet werden.

8. Decoder für hierarchisch in mehreren Teilkanälen (1,2,3) übertragene oder aufgezeichnete digitale Signale, wobei die übergeordneten Teilkanäle (1,2) einen höheren Fehlerschutz aufweisen als die ihnen untergeordneten Teilkanäle (2,3), der die folgenden Bestandteile enthält:
- Kanalschnittstelle (ME) zum Zusammenfassen der Signale der Teilkanäle (1-3) mit unterschiedlichem Fehlerschutz zu Teilsignalen, die Datenpakete (TV,HD1,HD2) und zugehörige Header-Informationen (TVP,HD1P,HDP2) enthalten, wobei das dem am besten geschützten Teilkanal (1) zugeordnete Teilsignal (TV,TVP) zur Wiedergabe mit normaler Auflösung ausreichend ist, derart, dass die Header-Informationen (HD1P,HDP2) mindestens eines Teilsignals für erhöhte Auflösung, dessen Datenpakete (HD1,HD2) einem untergeordneten Teilkanal (2,3) zugeordnet sind, aus einem anderen Teilkanal (1,2) transferiert werden, der diesem übergeordnet ist; und
- Quellendecoder (VD1,VD2) zum Dekodieren der Daten der Teilsignale zu Videosignalen.

9. Decoder nach Anspruch 8, wobei eine encoderseitige Kennzeichnung der Transportpakete, in denen Header-Informationen übertragen werden, ausgewertet wird.

10. Verfahren, Encoder oder Decoder nach einem der vorherigen Ansprüche, wobei die digitalen Signale oder Datenpakete Audio- und/oder Videodaten enthalten, und es sich bei der normalen Wiedergabequalität um TV-Auflösung und bei verbesserter Wiedergabequalität um HDTV-Auflösung handelt.

## Claims

1. Method for the transmission or recording of digital data packets, which contain data (TV, HD1, HD2) and header information items (TVP, HD1P, HD2P), whereby a first part of the data and the associated header information items (TV, TVP) are sufficient for the reproduction in normal quality, and further parts of the data (HD1, HD2) together with their associated header information items (HD1P, HDP2) enable the reproduction in an improved quality, containing the following steps:
- partitioning of the data (TV, HD1, HD2) and their header information items (TVP, HD1P, HD2P) to several hierarchic subchannels (1 - 3), whereby the data (TV, HD1) for normal reproduction quality and the header information items for improved reproduction quality (HD1P, HDP2) are assigned to the same subchannel (1, 2); and
- transmission or recording of the subchannels (1 - 3) with a different good error protection level, whereby the same error protection level is valid for the data within one subchannel, and whereby superordinate subchannels (1, 2) have a better error protection than the subordinate subchannels (2, 3), and whereby the data (TV, TVP) sufficient for the reproduction in normal quality are transmitted or recorded in the subchannel (1) with the best error protection.

2. Method according to claim 1, whereby the header information items (HD1P, HDP2), which are assigned to a superordinate subchannel, are in each case assigned to the directly superordinate subchannel (1, 2).

3. Method according to one of claims 1 or 2, whereby the header information items (TVP), which belong to the data (TV) with the least resolution and which are transmitted in the best-protected subchannel (1), are transmitted several times.

4. Method according to one of claims 1 to 3, whereby the transmission is effected in accordance with an MPEG system multiplex and whereby those transport packets containing header information items (TVP, HD1P, HDP2) are marked by setting a priority bit (TP).

5. Method for the decoding of digital signals which are hierarchically transmitted or recorded in a plurality of subchannels (1 - 3), whereby the superordinate subchannels (1, 2) have a better error protection than the subchannels (2, 3) which are subordinate to them, the method containing the following steps:
- combining the signals of the subchannels (1 - 3) to subsignals, which contain data packets (TV, HD1, HD2) and associated header information items (TVP, HD1P, HDP2), whereby the subsignal (TV, TVP) assigned to the best protected subchannel (1) is sufficient for the reproduction in normal quality, in such a way, that the header information items (HD1P, HDP2) of at least one subsignal for higher quality, whose data packets (HD1, HD2) are assigned to a subordinate subchannel (2, 3), are transferred from another subchannel (1, 2), which is superordinate; and
- decoding of the data of the subsignals to video signals.

6. Encoder for the hierarchic transmission or recording of digital signals in a plurality of subchannels (1, 2, 3), whereby the superordinate subchannels have a better error protection than their subordinate subchannels, which contains the following components:
- source coders (VE1, VE2) for a hierarchic coding in several subsignals, which contain data packets (TV, HD1, HD2) and associated header information items (TVP, HD1P, HDP2), whereby one of these subsignals (TV, TVP) is sufficient for the reproduction in normal quality;
- channel interface (SP) for the partition of the subsignals to the subchannels (1 - 3) with different error protection levels, whereby the subsignal (TV, TVP) sufficient for the reproduction in normal resolution is assigned to the best protected subchannel (1), and whereby to at least one subchannel (1, 2) are assigned the header information items (HD1P, HDP2) of a subsignal, whose data packets (HD1, HD2) are assigned to another, subordinate subchannel.

7. Encoder according to claim 6, whereby the transport packets, in which header information items are transmitted or recorded, are identified.

8. Decoder for digital signals which are hierarchically transmitted or recorded in a plurality of subchannels (1, 2, 3), whereby the superordinate subchannels (1, 2) have a higher error protection level than the subchannels (2, 3) which are subordinate to them, which contains the following components:
- channel interface (ME) for combining the signals of the subchannels (1 - 3) with different error protection levels to subsignals, which contain data packets (TV, HD1, HD2) and associated header information items (TVP, HD1P, HDP2), whereby the subsignal (TV, TVP) assigned to the best protected subchannel (1) is sufficient for the reproduction in a normal resolution, in such a way, that the header information items (HD1P, HDP2) of at least one subsignal for a higher resolution, whose data packets (HD1, HD2) are assigned to a subordinate subchannel (2, 3), are transferred from another subchannel (1, 2), which is superordinate; and
- source decoder (VD1, VD2) for the decoding of the data of the subsignals to video signals.

9. Decoder according to claim 8, whereby an encoder-side identification of the transport packets, in which header information items are transmitted, is evaluated.

10. Method, encoder or decoder according to one of the preceding claims, whereby the digital signals or data packets contain audio and/or video data, and whereby the normal reproduction comprehends TV resolution quality and an improved reproduction quality comprehends HDTV resolution.

## Revendications

1. Procédé de transmission ou d'enregistrement de paquets de données numériques contenant des données (TV, HD1, HD2) et des informations d'en-tête (TVP, HD1 P, HD2P), où une première partie des données et les informations d'en-tête correspondantes (TV, TVP) suffisent à une restitution en qualité standard, et d'autres parties des données (HD1, HD2) avec les informations d'en-tête correspondantes (HD1 P, HDP2) permettent une restitution en qualité améliorée, comprenant les étapes suivantes:
- répartition des données (TV, HD1, HD2) et des informations d'en-tête correspondantes (TVP, HD1P, HD2P) sur plusieurs canaux partiels hiérarchiques (1 à 3) où les données (TV, HD1) pour une qualité de restitution standard ainsi que les informations d'en-tête pour une qualité de restitution améliorée (HD1P, HD2P), sont affectées au même canal partiel (1,2) ; et
- transmission ou enregistrement des canaux partiels (1 à 3) avec différents niveaux de protection contre les erreurs, le niveau de protection contre les erreurs étant le même pour toutes les données du même canal partiel et les canaux partiels supérieurs (1, 2 ) offrant une meilleure protection que les canaux partiels subordonnés (2, 3), et où les données suffisantes pour une restitution en qualité standard (TV, TVP) sont transmises ou enregistrées via le canal partiel (1) offrant la meilleure protection contre les erreurs.

2. Procédé selon la revendication 1, dans lequel les informations d'en-tête (HD1 P, HDP2) affectées à un canal partiel supérieur sont affectées au canal partiel directement supérieur.

3. Procédé selon une des revendications 1 ou 2 dans lequel les informations d'en-tête (TVP) correspondant aux données (TV) de la résolution la plus faible et qui sont transmises par le canal partiel le mieux protégé (1 ), sont transmises plusieurs fois.

4. Procédé selon une des revendications 1 à 3 dans lequel la transmission s'opère conformément au multiplexage des systèmes MPEG et les paquets de transport contenant des informations d'en-tête (TVP, HD1 P, HDP2) sont marqués par définition d'un bit de priorité (TP).

5. Procédé de décodage de signaux numériques transmis ou enregistrés de manière hiérarchique via plusieurs canaux partiels (1 à 3) dans lequel les canaux partiels supérieurs (1, 2) offrent une meilleure protection contre les erreurs que les canaux partiels qui leur sont subordonnés (2, 3) et comprenant les étapes suivantes:
- regroupement des signaux des canaux partiels (1 à 3) en signaux partiels comprenant des paquets de données (TV, HD1, HD2) et les informations d'en-tête correspondantes (TVP, HD1P, HDP2), où le signal partiel (TV, TVP) affecté au canal partiel le mieux protégé (1) est suffisant pour une restitution en qualité standard, de sorte que les informations d'en-tête (HD1 P, HDP2) d'au moins un signal partiel destiné à une restitution en qualité supérieure dont les paquets de données (HD1, HD2) sont affectés à un canal partiel subordonné (2, 3), soient transférées à partir d'un autre canal partiel (1, 2) supérieur à celui-ci ; et
- décodage des données des signaux partiels en signaux vidéo.

6. Encodeur pour la transmission hiérarchique ou l'enregistrement de signaux numériques via plusieurs canaux partiels (1, 2, 3), les canaux partiels supérieurs offrant une meilleure protection contre les erreurs que les canaux partiels qui leur sont subordonnés, comprenant les éléments suivants :
- un encodeur source (VE1, VE2) permettant un codage hiérarchique en plusieurs signaux partiels comprenant des paquets de données (TV, HD1, HD2) et les informations d'en-tête correspondantes (TVP, HD1 P, HDP2), l'un de ces signaux partiels (TV, TVP) étant suffisant pour une restitution en qualité standard ;
- une interface de canaux (SP) pour la répartition des signaux partiels sur les canaux partiels (1 à 3) offrant différents niveaux de protection contre les erreurs, le signal partiel (TV, TVP) suffisant pour une restitution en résolution standard étant affecté au canal partiel le mieux protégé (1), les informations d'en-tête (HD1P, HDP2) d'un signal partiel étant affectées à au moins un canal partiel et les paquets de données correspondants (HD1, HD2) étant affectés à un autre canal partiel subordonné à celui-ci.

7. Encodeur selon la revendication 6 permettant un marquage des paquets de transport dans lesquels sont transmises ou enregistrées des informations d'en-tête.

8. Décodeur pour signaux numériques transmis ou enregistrés de façon hiérarchique via plusieurs canaux partiels (1, 2, 3), les canaux partiels supérieurs (1, 2) offrant une meilleure protection contre les erreurs que les canaux partiels qui leur sont subordonnés (2, 3), comprenant les éléments suivants :
- une interface de canaux (ME) pour le regroupement des signaux des canaux partiels (1 à 3) à niveaux de protection différents en signaux partiels contenant des paquets de données (TV, HD1, HD2) et les informations d'en-tête correspondantes (TVP, HD1 P, HDP2), où le signal partiel (TV, TVP) affecté au canal partiel le mieux protégé (1) est suffisant pour une restitution en résolution standard, de sorte que les informations d'en-tête (HD1P, HDP2) d'au moins un canal partiel destiné à une restitution en résolution supérieure dont les paquets de données (HD1, HD2) sont affectés à un canal partiel subordonné (2, 3), soient transférées à partir d'un autre canal partiel (1, 2) supérieur à celui-ci ; et
- un décodeur source (VD1, VD2) permettant le décodage des données des signaux partiels en signaux vidéo.

9. Décodeur selon la revendication 8 permettant une analyse du marquage des paquets de transport, effectué côté encodeur, dans lesquels sont transmises des informations d'en-tête.

10. Procédé, encodeur où décodeur selon une des revendications précitées, où les signaux numériques ou paquets de données contiennent des données audio et/ou vidéo et où il s'agit pour la qualité de restitution normale d'une résolution TV et pour la qualité de restitution améliorée d'une résolution HDTV.
